(19) Europäisches Patentamt
European Patent Office
Office européen des brevets

(11) **EP 2 936 488 B1**

(12) **FASCICULE DE BREVET EUROPEEN**

(45) Date de publication et mention
de la délivrance du brevet:
**09.11.2016 Bulletin 2016/45**

(51) Int Cl.:
**G10L 19/025** *(2013.01)*    **G10L 21/02** *(2013.01)*
**H04B 3/21** *(2006.01)*    **G10L 19/26** *(2013.01)*
**G10L 21/0364** *(2013.01)*

(21) Numéro de dépôt: **13820844.2**

(22) Date de dépôt: **20.12.2013**

(86) Numéro de dépôt international:
**PCT/FR2013/053216**

(87) Numéro de publication internationale:
**WO 2014/096733 (26.06.2014 Gazette 2014/26)**

(54) **ATTÉNUATION EFFICACE DE PRÉ-ÉCHOS DANS UN SIGNAL AUDIONUMÉRIQUE**

WIRKSAME DÄMPFUNG VON VORECHOS IN EINEM DIGITALEN AUDIOSIGNAL

EFFECTIVE ATTENUATION OF PRE-ECHOS IN A DIGITAL AUDIO SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.12.2012 FR 1262598**

(43) Date de publication de la demande:
**28.10.2015 Bulletin 2015/44**

(73) Titulaire: **Orange**
**75015 Paris (FR)**

(72) Inventeurs:
• **KOVESI, Balazs**
**F- 22300 Lannion (FR)**

• **RAGOT, Stéphane**
**F- 22300 Lannion (FR)**

(56) Documents cités:
**FR-A1- 2 888 704    FR-A1- 2 897 733**

• **"G.729 based Embedded Variable bit-rate coder: An 8-32 kbit/s scalable wideband coder bitstream interoperable with G.729; G.729.1 (05/06)", ITU-T DRAFT STUDY PERIOD 2005-2008, INTERNATIONAL TELECOMMUNICATION UNION, GENEVA ; CH, no. G.729.1 (05/06), 29 mai 2006 (2006-05-29), XP017404590,**

**Description**

L'invention concerne un procédé et un dispositif de traitement d'atténuation des pré-échos lors du décodage d'un signal audionumérique.

Pour la transmission des signaux audionumériques sur des réseaux de télécommunications, qu'il s'agisse par exemple de réseaux fixes ou mobiles, ou pour le stockage des signaux, on fait appel à des processus de compression (ou codage source) mettant en oeuvre des systèmes de codage qui sont en général du type codage temporel par prédiction linéaire ou codage fréquentiel par transformée.

Le procédé et le dispositif, objets de l'invention, ont ainsi comme domaine d'application la compression des signaux sonores, en particulier les signaux audionumériques codés par transformée fréquentielle.

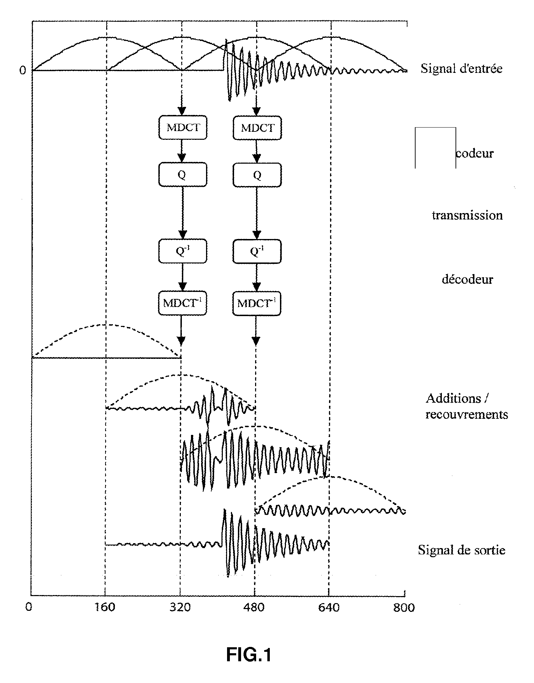

La figure 1 représente à titre illustratif, un schéma de principe du codage et du décodage d'un signal audio numérique par transformée incluant une analyse-synthèse par addition/recouvrement selon l'art antérieur.

Certaines séquences musicales, telles que les percussions et certains segments de parole comme les plosives (/k/, /t/, ...), sont caractérisées par des attaques extrêmement brusques qui se traduisent par des transitions très rapides et une variation très forte de la dynamique du signal en l'espace de quelques échantillons. Un exemple de transition est donné à la figure 1 à partir de l'échantillon 410.

Pour le traitement de codage/décodage, le signal d'entrée est découpé en blocs d'échantillons de longueur L dont les frontières sont représentées sur la figure 1 par des traits verticaux en pointillés. Le signal d'entrée est noté $x(n)$, où n est l'indice de l'échantillon. La découpe en blocs successifs (ou trames) conduit à définir les blocs $X_N(n) = [x(N.L) ... x(N.L+L-1)] = [x_N(0) .... x_N(L-1)]$, où N est l'indice du bloc (ou de la trame), L est la longueur de la trame. A la figure 1 on a L=160 échantillons. Dans le cas de la transformée modulée en cosinus modifiée MDCT (pour "Modified Discrète Cosine Transform" en anglais), deux blocs $X_N(n)$ et $X_{N+1}(n)$ sont analysés conjointement pour donner un bloc de coefficients transformés associés à la trame d'indice N et la fenêtre d'analyse est sinusoïdale.

La division en blocs, aussi appelés trames, opérée par le codage par transformée est totalement indépendante du signal sonore et les transitions peuvent donc apparaître en un point quelconque de la fenêtre d'analyse. Or après décodage par transformée, le signal reconstmit est entaché de "bruit" (ou distorsion) engendré par l'opération quantification (Q)-quantification inverse ($Q^{-1}$). Ce bruit de codage est réparti temporellement de façon relativement uniforme sur tout le support temporel du bloc transformé, c'est-à-dire sur toute la longueur de la fenêtre de longueur 2L d'échantillons (avec recouvrement de L échantillons). L'énergie du bruit de codage est en général proportionnelle à l'énergie du bloc et est fonction du débit de codage/décodage.

Pour un bloc comportant une attaque (comme le bloc 320-480 de la figure 1) l'énergie du signal est élevée, le bruit est donc également de niveau élevé.

En codage par transformée, le niveau du bruit de codage est typiquement inférieur à celui du signal pour les segments de forte énergie qui suivent immédiatement la transition, mais le niveau est supérieur à celui du signal pour les segments d'énergie plus faible, notamment sur la partie précédant la transition (échantillons 160 - 410 de la figure 1). Pour la partie précitée, le rapport signal à bruit est négatif et la dégradation résultante peut apparaître très gênante à l'écoute. On appelle pré-écho le bruit de codage antérieur à la transition et post-écho le bruit postérieur à la transition.

On peut observer sur la figure 1 que le pré-écho affecte la trame précédant la transition ainsi que la trame où se produit la transition.

Les expériences psycho-acoustiques ont montré que l'oreille humaine effectue un pré-masquage temporel des sons assez limité, de l'ordre de quelques millisecondes. Le bruit précédant l'attaque, ou pré-écho, est audible lorsque la durée du pré-écho est supérieure à la durée du pré-masquage.

L'oreille humaine effectue également un post-masquage d'une durée plus longue, de 5 à 60 millisecondes, lors du passage de séquences de forte énergie à des séquences de faible énergie. Le taux ou niveau de gêne acceptable pour les post-échos est donc plus important que pour les pré-échos.

Le phénomène des pré-échos, plus critique, est d'autant plus gênant que la longueur des blocs en nombre d'échantillons est importante. Or, en codage par transformée, il est bien connu que pour les signaux stationnaires plus la longueur de la transformée augmente, plus le gain de codage est important. A fréquence d'échantillonnage fixée et à débit fixé, si on augmente le nombre de points de la fenêtre (donc la longueur de la transformée) on disposera de plus de bits par trame pour coder les raies fréquentielles jugées utiles par le modèle psychoacoustique, d'où l'avantage d'utiliser des blocs de grande longueur. Le codage MPEG AAC (Advanced Audio Coding), par exemple, utilise une fenêtre de grande longueur qui contient un nombre fixe d'échantillons, 2048, soit sur une durée de 64 ms si la fréquence d'échantillonnage est de 32 kHz; le problème des pré-échos y est géré en permettant de commuter de ces fenêtres longues à 8 fenêtres courtes par le biais de fenêtres intermédiaires (dites de transition), ce qui nécessite un certain retard au codage pour détecter la présence d'une transition et adapter les fenêtres. La longueur de ces fenêtres courtes est donc de 256 échantillons (8 ms à 32 kHz). A bas débit on peut toujours avoir un pré-écho audible de quelques ms. La commutation des fenêtres permet d'atténuer le pré-écho mais pas de le supprimer. Les codeurs par transformée utilisés pour les applications conversationnelles, comme UIT-T G.722.1, G.722.1C ou G.719, utilisent souvent une longueur de trame de 20 ms et une fenêtre de durée 40 ms à 16, 32 ou 48 kHz (respectivement). On peut noter que le codeur UIT-T G.719 intègre un mécanisme de commutation de fenêtres avec détection de transitoire, cependant le pré-écho n'est pas complètement réduit à bas débit (typiquement à 32 kbit/s).

Dans le but de réduire l'effet gênant précité du phénomène des pré-échos, différentes solutions ont été proposées au niveau du codeur et/ou du décodeur.

La commutation de fenêtres a été citée précédemment ; elle nécessite de transmettre une information auxiliaire pour identifier le type de fenêtres utilisées dans la trame courante. Une autre solution consiste à appliquer un filtrage adaptatif. Dans la zone précédant l'attaque, le signal reconstruit est vu comme la somme du signal original et du bruit de quantification.

Une technique de filtrage correspondante a été décrite dans l'article intitulé High Quality Audio Transform Coding at 64 kbits, IEEE Trans. on Communications Vol 42, No. 11, November 1994, publié par Y. Mahieux et J. P. Petit.

La mise en oeuvre d'un tel filtrage nécessite la connaissance de paramètres dont certains, comme les coefficients de prédiction et la variance du signal corrompu par le pré-écho, sont estimés au décodeur à partir des échantillons bruités. Par contre, des informations telles que l'énergie du signal d'origine ne peuvent être connues qu'au codeur et doivent par conséquent être transmises. Ceci nécessite de transmettre des informations supplémentaires, ce qui à débit contraint diminue le budget relatif alloué au codage par transformée. Lorsque le bloc reçu contient une variation brusque de dynamique, le traitement de filtrage lui est appliqué.

Le processus de filtrage précité ne permet pas de retrouver le signal d'origine, mais procure une forte réduction des pré-échos. Il nécessite toutefois de transmettre les paramètres supplémentaires au décodeur.

A la différence des solutions précédentes, différentes techniques de réduction de pré-écho sans transmission spécifique de l'information ont été proposées. Par exemple, une revue de la réduction de pré-échos dans le contexte du codage hiérarchique est présentée dans l'article B. Kövesi, S. Ragot, M. Gartner, H. Taddei, "Pre-echo réduction in the ITU-T G.729.1 embedded coder," EUSIPCO, Lausanne, Suisse, Août 2008.

Un exemple typique de procédé d'atténuation de pré-échos sans information auxiliaire est décrit dans la demande de brevet français FR 08 56248. Dans cet exemple, on détermine des facteurs d'atténuation par sous-bloc, dans les sous-blocs de faible énergie précédant un sous-bloc dans lequel une transition ou attaque a été détectée.

Le facteur d'atténuation $g(k)$ dans le k-ième sous-bloc est calculé par exemple en fonction du rapport $R(k)$ entre l'énergie du sous-bloc de plus forte énergie et l'énergie du k-ième sous-bloc en question :

$$g(k) = f(R(k))$$

où $f$ est une fonction décroissante à valeurs entre 0 et 1 et k est le numéro du sous-bloc. D'autres définitions du facteur $g(k)$ sont possibles, par exemple en fonction de l'énergie $En(k)$ dans le sous-bloc courant et de l'énergie $En(k-1)$ dans le sous-bloc précédent.

Si l'énergie des sous-blocs varie peu par rapport à l'énergie maximale dans les sous-blocs considérés à la trame courante, aucune atténuation n'est alors nécessaire ; le facteur $g(k)$ est fixé à une valeur d'atténuation inhibant l'atténuation, c'est-à-dire 1. Sinon, le facteur d'atténuation est compris entre 0 et 1.

Dans la plupart des cas, surtout quand le pré-écho est gênant, la trame qui précède la trame de pré-écho a une énergie homogène qui correspond à l'énergie d'un segment de faible énergie (typiquement un bruit de fond). Selon l'expérience il n'est pas utile ni même souhaitable qu'après traitement d'atténuation de pré-écho l'énergie du signal devienne inférieure à l'énergie moyenne (par sous-bloc) du signal précédant la zone de traitement - typiquement celle de la trame précédente, notée $\overline{En}$, ou celle de la deuxième moitié de la trame précédente, notée $\overline{En'}$.

Pour le sous-bloc d'indice k à traiter on peut calculer la valeur limite, notée $\lim_g(k)$, du facteur d'atténuation afin d'obtenir exactement la même énergie que l'énergie moyenne par sous-bloc du segment précédant le sous-bloc à traiter. Cette valeur est bien sûr limitée à un maximum de 1 puisqu'on s'intéresse ici aux valeurs d'atténuation. Plus précisément on définit ici:

$$\lim_g(k) = \min\left(\sqrt{\frac{\max\left(\overline{En}, \overline{En'}\right)}{En(k)}}, 1\right)$$

où l'énergie moyenne du segment précédent est approximée par la valeur max $(\overline{En}, \overline{En'})$.

La valeur $\lim_g(k)$ ainsi obtenue sert de limite inférieure dans le calcul final du facteur d'atténuation du sous-bloc, elle est donc utilisée comme suit :

$$g(k) = \max\left(g(k), \lim_{g}(k)\right)$$

Les facteurs d'atténuation (ou gains) $g(k)$ déterminés par sous-blocs peuvent être ensuite lissés par une fonction de lissage appliquée échantillon par échantillon pour éviter des variations brusques du facteur d'atténuation aux frontières des blocs.

Par exemple, on peut d'abord définir le gain par échantillon comme une fonction constante par morceaux :

$$g_{pre}(n) = g(k), \; n = kL', \cdots, (k+1)L' - 1$$

où L' représente la longueur d'un sous-bloc.
La fonction est ensuite lissée suivant l'équation suivante:

$$g_{pre}(n) := \alpha g_{pre}(n-1) + (1-\alpha) g_{pre}(n), \; n = 0, \cdots, L-1$$

avec la convention que $g_{pre}(-1)$ est le dernier facteur d'atténuation obtenu pour le dernier échantillon du sous-bloc précédent, $\alpha$ est le coefficient de lissage, typiquement $\alpha=0.85$.

D'autres fonctions de lissage sont également possibles comme par exemple le fondu enchainé linéaire sur u échantillons :

$$g_{pre}(n) = \frac{1}{u} \sum_{i=0}^{u-1} g_{pre}'(n-i), \; n = 0, \cdots, L-1$$

où $g_{pre}'(n)$ est l'atténuation non lissée et $g_{pre}(n)$ est l'atténuation lissée, $g_{pre}'(n)$ avec $n = -(u-1), \cdots -1$ sont les derniers u-1 facteurs d'atténuation obtenus pour les derniers échantillons du sous-bloc précédent. On peut par exemple prendre u = 5.

Une fois les facteurs $g_{pre}(n)$ ainsi calculés, l'atténuation de pré-échos est faite sur le signal reconstruit dans la trame courante, $x_{rec}(n)$, en multipliant chaque échantillon par le facteur correspondant :

$$x_{rec,g}(n) = g_{pre}(n)x_{rec}(n), \; n = 0, \cdots, L-1$$

où $x_{rec,g}(n)$ est le signal décodé et post-traité par la réduction de pré-écho.

Les **figures 2 et 3** illustrent la mise en oeuvre du procédé d'atténuation tel que décrit dans la demande de brevet de l'état de l'art, précitée, et résumé précédemment.

Dans ces exemples le signal est échantillonné à 32 kHz, la longueur de la trame est L=640 échantillons et chaque trame est divisée en 8 sous-blocs de K=80 échantillons.

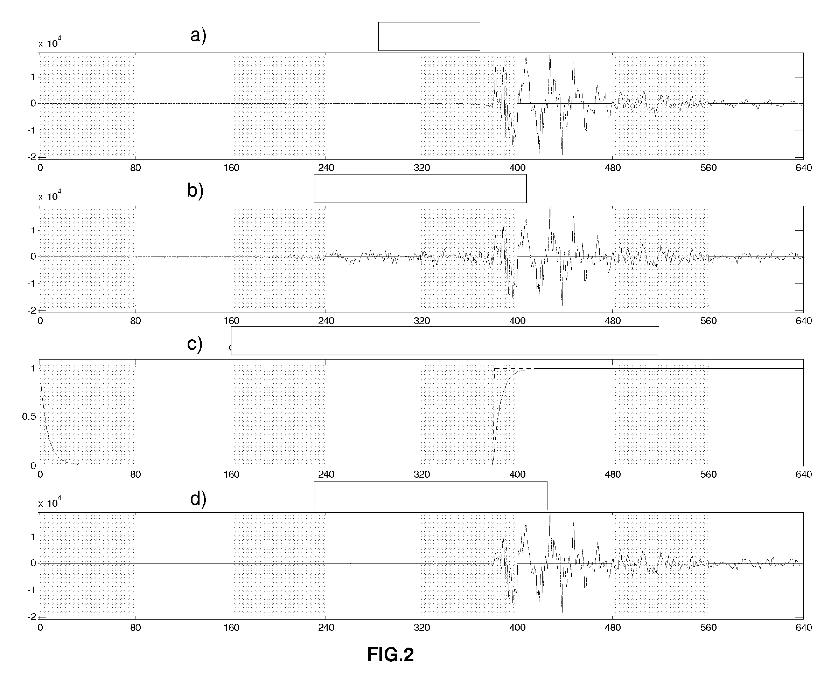

Dans la partie a) de la figure 2, une trame d'un signal original échantillonné à 32 kHz, est représentée. Une attaque (ou transition) dans le signal est située dans le sous-bloc commençant à l'indice 320. Ce signal a été codé par un codeur par transformée de type MDCT à bas débit (24 kbit/s).

Dans la partie b) de la figure 2, le résultat du décodage sans traitement de pré-écho est illustré. On peut observer le pré-écho à partir de l'échantillon 160, dans les sous-blocs précédents celui contenant l'attaque.

La partie c) montre l'évolution du facteur d'atténuation de pré-écho (ligne continue) obtenu par le procédé décrit dans la demande de brevet de l'état de l'art précitée. La ligne pointillée représente le facteur avant lissage. On remarque ici que la position de l'attaque est estimée autour de l'échantillon 380 (dans le bloc délimité par les échantillons 320 et 400).

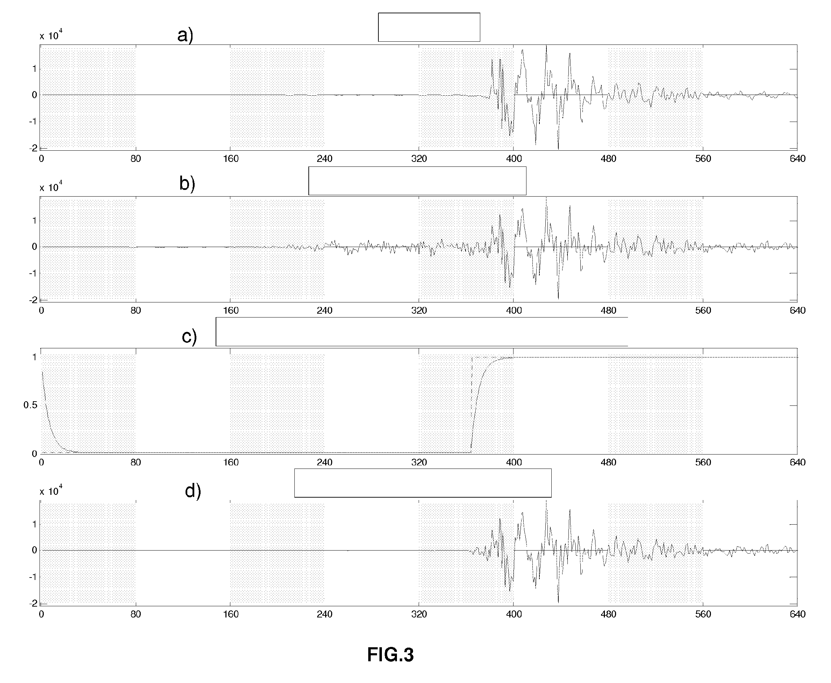

La partie d) illustre le résultat du décodage après application du traitement de pré-écho (multiplication du signal b) avec le signal c)). On voit que le pré-écho a bien été atténué. La figure 2 montre également que le facteur lissé ne remonte pas à 1 au moment de l'attaque, ce qui implique une diminution de l'amplitude de l'attaque. L'impact perceptible de cette diminution est très faible mais peut néanmoins être évité. La figure 3 illustre le même exemple que la figure 2, dans lequel, avant lissage, la valeur de facteur d'atténuation est forcée à 1 pour les quelques échantillons du sous-bloc précédant le sous-bloc où se situe l'attaque. La partie c) de la figure 3 donne un exemple d'une telle correction.

Dans cet exemple on a affecté la valeur de facteur 1 aux 16 derniers échantillons du sous-bloc précédant l'attaque, à partir de l'indice 364. Ainsi la fonction de lissage accroît progressivement le facteur pour avoir une valeur proche de 1 au moment de l'attaque. L'amplitude de l'attaque est alors préservée, comme illustré dans la partie d) de la figure 3, par contre quelques échantillons de pré-écho ne sont pas atténués.

Dans l'exemple de la figure 3 la réduction de pré-écho par atténuation ne permet pas de réduire le pré-écho jusqu'au niveau de l'attaque, à cause du lissage du gain.

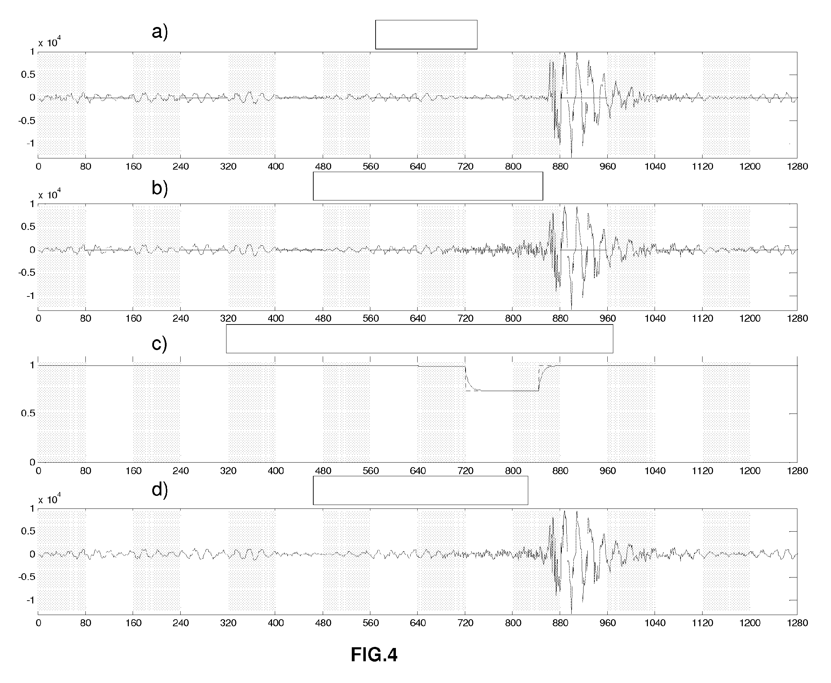

Un autre exemple avec le même réglage que celui de la figure 3 est illustré sur la **figure 4.** Cette figure représente 2 trames pour mieux montrer la nature du signal avant l'attaque. Ici, l'énergie du signal original avant l'attaque est plus forte (partie a)) que dans le cas illustré par la figure 3, et le signal avant l'attaque est audible (échantillons 0 - 850). Sur la partie b) on peut observer le pré-écho sur le signal décodé sans traitement de pré-écho dans la zone 700-850. Selon la procédure de limitation de l'atténuation expliquée précédemment on atténue l'énergie du signal de la zone de pré-écho jusqu'à l'énergie moyenne du signal précédant la zone de traitement. On observe sur la partie c) que le facteur d'atténuation calculé en tenant compte de la limitation d'énergie est proche de 1 et que le pré-écho est toujours présent sur la partie d) après application du traitement de pré-écho (multiplication du signal b) avec le signal c)), malgré la bonne mise à niveau du signal dans la zone pré-écho. On peut en effet bien distinguer ce pré-écho sur la forme d'onde où on remarque qu'une composante haute fréquence est superposée au signal dans cette zone.

Cette composante haute fréquence est bien audible et gênante, et l'attaque est moins nette (partie d) figure 4).

L'explication de ce phénomène est la suivante : dans le cas d'une attaque très brusque, impulsive (comme illustrée sur la figure 4) le spectre du signal (dans la trame contenant l'attaque) est plutôt blanc et donc contient également beaucoup de hautes fréquences. Ainsi le bruit de quantification est également étalé et relativement plat en fréquences (blanc) et composé de hautes fréquences, ce qui n'est pas le cas du signal précédant la zone de pré-écho. Il y a donc un changement brusque dans le spectre d'une trame à l'autre, qui résulte en un pré-écho audible malgré le fait que l'énergie a été mise au bon niveau.

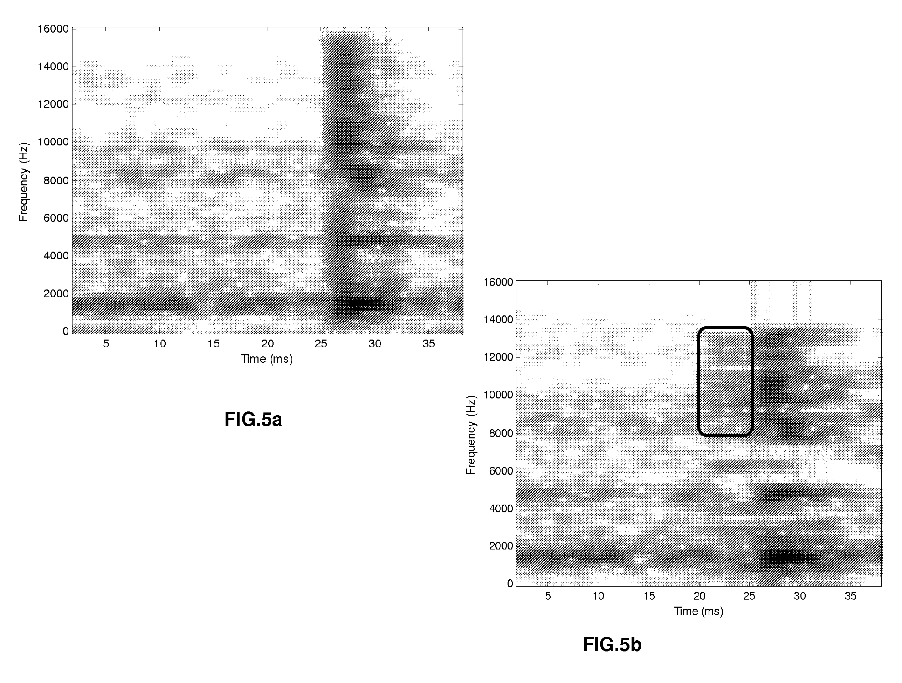

Ce phénomène est à nouveau représenté sur les **figures 5a et 5b** qui montrent respectivement les spectrogrammes du signal original en 5a, correspondant au signal représenté en partie a) de la figure 4 et le spectrogramme du signal avec atténuation de pré-échos selon l'état de l'art, en 5b, correspondant au signal représenté en partie d) de la figure 4.

On remarque bien un pré-écho encore audible dans la partie encadrée à la figure 5b.

Autres exemples de ces procédés d'atténuation de pré-échos sont décrits dans les demandes de brevet FR2897733 et FR2888704. aussi bien que dans la ITU-T Recommendation G.729.1. "G.729 based Embedded Variable bit-rate coder: An 8-32 kbit/s scalable wideband coder bitstream interoperable with G.729" (05/2006).

Il existe donc un besoin d'une technique améliorée d'atténuation de pré-échos au décodage, qui permette d'atténuer les hautes fréquences indésirables et plus généralement les pré-échos parasites de façon précise et universelle et sans qu'aucune information auxiliaire ne soit transmise par le codeur.

La présente invention améliore la situation de l'état de l'art.

A cet effet, la présente invention traite d'un procédé de traitement d'atténuation de pré-écho dans un signal audionumérique décodé selon un décodage par transformée. Le procédé est tel qu'il comporte les étapes suivantes:

- décomposition du signal décodé en au moins deux sous-signaux selon un critère de décomposition prédéterminé;
- calcul de facteurs d'atténuation par sous-signal et par échantillon d'une zone de pré-écho préalablement déterminée;
- atténuation de pré-écho dans la zone de pré-écho de chacun des sous-signaux par application des facteurs d'atténuation aux sous-signaux; et
- obtention du signal atténué par combinaison des sous-signaux atténués.

Ainsi, le procédé permet de contrôler de façon précise, l'atténuation à appliquer à chacun des sous-signaux. Ces sous-signaux ont des composantes représentatives de caractéristiques particulières du signal décodé, selon le critère de décomposition choisi. Ainsi, la quantité d'atténuation à appliquer pour ces différentes caractéristiques peut être adaptée. L'atténuation de pré-écho dans ce signal décodé est alors plus précise et plus efficace.

Les différents modes particuliers de réalisation mentionnés ci-après peuvent être ajoutés indépendamment ou en combinaison les uns avec les autres, aux étapes du procédé défini ci-dessus.

Dans un premier mode de réalisation, le critère de décomposition prédéterminé est un critère fréquentiel.

Ainsi, l'atténuation est adaptée de façon précise aux caractéristiques fréquentielles du signal décodé.

Dans un mode particulier de réalisation, la décomposition du signal décodé s'effectue par un premier filtrage passe bas ou passe haut pour obtenir un premier sous-signal.

Un premier sous-signal comporte donc des composantes basses fréquences dans le cas d'un filtrage passe-bas ou des composantes hautes fréquences dans le cas d'un filtrage passe-haut. L'atténuation pour ce premier sous-signal est adaptée à ses composantes fréquentielles.

Selon un mode possible de réalisation, la décomposition du signal s'effectue en outre par un second filtrage passe haut ou passe bas, complémentaire au premier filtrage, pour obtenir un deuxième sous-signal.

Un deuxième sous-signal comporte donc des composantes hautes fréquences dans le cas d'un filtrage passe-haut complémentaire ou des composantes basses fréquences dans le cas d'un filtrage passe-bas complémentaire.

L'atténuation pour ce deuxième sous-signal est aussi adaptée à ses composantes fréquentielles.

Selon un autre mode possible de réalisation, un deuxième sous-signal est obtenu par soustraction du premier sous-signal au signal décodé, de façon à éviter un deuxième filtrage pour obtenir le deuxième sous-signal. Ceci réduit donc la complexité de l'étape de décomposition du procédé.

De façon particulière, le filtrage est à réponse impulsionnelle finie à phase nulle de fonction de transfert:

$$c(n)z^{-1} + \left(1 - 2c(n)\right) + c(n)z$$

avec c(n) un coefficient compris entre 0 et 0.25.

Ce type de filtrage est de faible complexité.

Dans une variante de réalisation, la décomposition du signal décodé s'effectue par filtrage QMF et PQMF pour obtenir des sous-signaux en sous-bandes.

Plusieurs sous-signaux sont ainsi obtenus, chacun des sous-signaux étant représenté dans une bande de fréquence différente. L'atténuation résultante permet ainsi de prendre en compte la répartition spectrale du pré-écho. L'atténuation est alors adaptée à ces caractéristiques spectrales.

Dans un deuxième mode de réalisation, le critère de décomposition prédéterminé est un critère de périodicité du signal.

Dans ce mode de réalisation, l'atténuation est adaptée aux caractéristiques de périodicité du signal. Un premier sous-signal comportant par exemple des composantes périodiques de type sinusoïdales et un second sous-signal comportant des composantes de bruit.

Selon un mode possible de réalisation, la zone de pré-écho est déterminée selon les étapes suivantes:

- détection d'une position d'attaque dans le signal décodé, avant l'étape de décomposition;
- détermination d'une zone de pré-écho précédant la position d'attaque détectée dans le signal décodé avant l'étape de décomposition ou dans les sous-signaux après l'étape de décomposition.

Ainsi, l'étape de détection de la position d'attaque est mutualisée pour tous les sous-signaux, permettant ainsi de réduire la complexité de traitement. L'étape de détermination d'une zone de pré-écho peut également être mutualisée pas soucis de faible complexité ou peut être faite dans les sous-signaux pour un bon compromis faible complexité/adaptation au signal.

Selon un autre mode possible de réalisation, la zone de pré-écho est déterminée selon les étapes suivantes:

- détection d'une position d'attaque dans chacun des sous-signaux obtenus après l'étape de décomposition;
- détermination d'une zone de pré-écho précédant la position d'attaque détectée dans chacun des sous-signaux.

La détection de la position d'attaque peut être effectuée de différente façon selon le sous-signal auquel elle est appliquée. Cela permet d'adapter au mieux la détection en fonction du sous-signal, au détriment d'une complexité de traitement plus importante.

De façon à simplifier encore le procédé selon un mode de réalisation de l'invention, pour au moins un sous-signal, le calcul du facteur d'atténuation s'effectue en utilisant au moins un paramètre de l'étape de détection d'une position d'attaque dans le signal décodé.

Ceci peut en effet être le cas pour le sous-signal comportant des composantes basses fréquences qui sont généralement beaucoup plus énergétiques que les composantes hautes fréquences, les énergies par sous-bloc du signal décodé $x_{rec}(n)$ et du sous-signal comportant majoritairement des composantes basses fréquences $x_{rec,ss1}(n)$ étant alors très proches. Il n'est donc plus nécessaire de recalculer des énergies des sous-blocs pour calculer le facteur d'atténuation du sous-signal car pour ce signal les valeurs d'énergie par sous-bloc sont déjà calculées pour détecter les attaques.

Dans un mode particulier de réalisation, une étape de lissage du facteur d'atténuation est appliquée pour au moins un sous-signal.

Ce lissage permet d'éviter les variations brusques du facteur d'atténuation aux frontières des blocs d'échantillons.

Dans un mode avantageux de réalisation, le facteur d'atténuation est forcé à 1 pour un nombre prédéterminé d'échantillons précédant le début de l'attaque.

Ainsi, le facteur d'atténuation a une valeur de 1 au moment de l'attaque, ce qui permet de préserver l'amplitude de l'attaque.

L'invention se rapporte également à un dispositif de traitement d'atténuation de pré-écho dans un signal audionumérique décodé à partir d'un décodeur par transformée. Ce dispositif est tel qu'il comprend:

- un module de décomposition du signal décodé en au moins deux sous-signaux selon un critère de décomposition prédéterminé;
- un module de calcul de facteurs d'atténuation par sous-signal et par échantillon d'une zone de pré-écho préalablement déterminée;
- un module d'atténuation de pré-écho dans la zone de pré-écho de chacun des sous-signaux par application des facteurs d'atténuation aux sous-signaux;
- un module d'obtention du signal atténué par combinaison des sous-signaux atténués.

Les avantages de ce dispositif sont les mêmes que ceux décrits pour le procédé de traitement d'atténuation qu'il met en oeuvre.

L'invention vise un décodeur d'un signal audionumérique comportant un dispositif tel que décrit précédemment.

L'invention vise aussi un programme informatique comportant des instructions de code pour la mise en oeuvre des étapes du procédé tel que décrit précédemment, lorsque ces instructions sont exécutées par un processeur.

Enfin, l'invention se rapporte à un support de stockage, lisible par un processeur, intégré ou non au dispositif de traitement, éventuellement amovible, mémorisant un programme informatique mettant en oeuvre un procédé de traitement tel que décrit précédemment.

D'autres caractéristiques et avantages de l'invention apparaîtront plus clairement à la lecture de la description suivante, donnée uniquement à titre d'exemple non limitatif, et faite en référence aux dessins annexés, sur lesquels:

- la figure 1 décrite précédemment illustre un système de codage-décodage par transformée selon l'état de l'art;
- la figure 2 décrite précédemment illustre un exemple de signal audionumérique pour lequel une méthode d'atténuation selon l'état de l'art est effectuée;
- la figure 3 décrite précédemment illustre un autre exemple de signal audionumérique pour lequel une méthode d'atténuation selon l'état de l'art est effectuée;
- la figure 4 décrite précédemment illustre encore un autre un exemple de signal audionumérique pour lequel une méthode d'atténuation selon l'état de l'art est effectuée;
- les figures 5a et 5b illustrent respectivement le spectrogramme du signal original et le spectrogramme du signal avec atténuation de pré-échos selon l'état de l'art (correspondant respectivement aux parties a) et d) de la figure 4);
- la figure 6 illustre un dispositif de traitement d'atténuation de pré-échos dans un décodeur de signal audionumérique, ainsi que les étapes mises en oeuvre par le procédé de traitement selon un mode de réalisation de l'invention;
- la figure 7a illustre la réponse fréquentielle d'un filtre passe bas mis en oeuvre selon un mode de réalisation de l'invention dans l'étape de décomposition du signal, pour différentes valeurs de paramètres du filtre;
- la figure 7b illustre la réponse fréquentielle d'un filtre passe haut mis en oeuvre selon un mode de réalisation de l'invention dans l'étape de décomposition du signal, pour différentes valeurs de paramètres du filtre;
- la figure 8 illustre un exemple de fenêtres d'analyse et de fenêtres de synthèse à faible retard pour le codage et le décodage par transformée susceptible de créer le phénomène de pré-écho;
- la figure 9 illustre un exemple de signal audionumérique pour lequel la méthode d'atténuation de pré-écho selon l'invention est mise en oeuvre;
- la figure 10 illustre un exemple de décomposition d'un signal audionumérique selon l'invention pour la mise en oeuvre du traitement d'atténuation de pré-écho;
- la figure 11 reprend les signaux de la figure 10 en zoomant sur les échantillons proches de la zone d'attaque;
- les figures 12a, 12b et 12c illustrent les spectrogrammes respectifs d'un signal audionumérique d'origine, du signal décodé sans traitement d'atténuation de pré-écho et du signal décodé avec traitement d'atténuation de pré-écho selon l'invention;
- la figure 13 illustre un exemple matériel de dispositif de traitement d'atténuation selon l'invention.

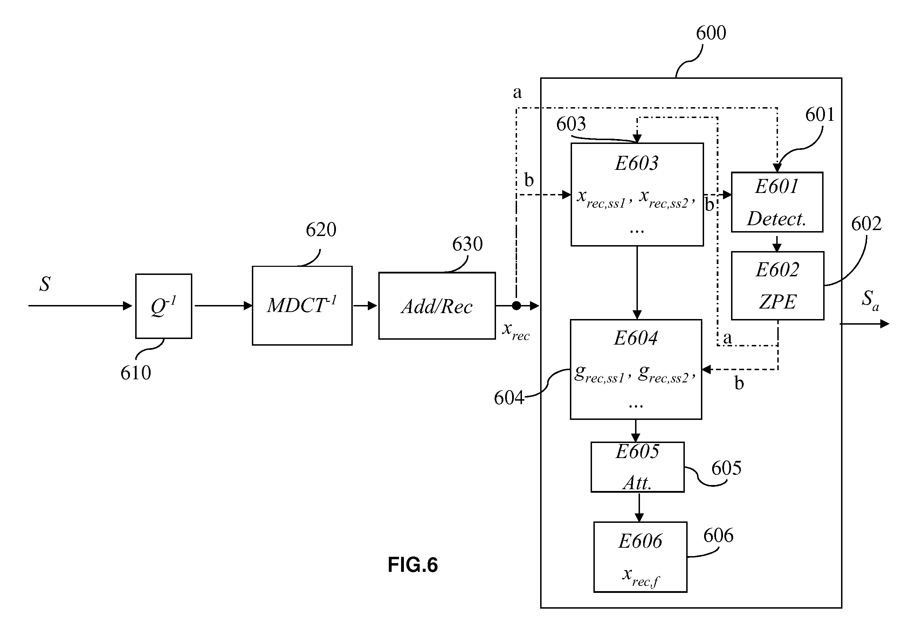

En référence à la figure 6, un dispositif 600 de traitement d'atténuation de pré-écho est décrit. Le dispositif de traitement d'atténuation 600 tel que décrit ci-après est compris dans un décodeur comportant un module 610 de quantification inverse ($Q^{-1}$) recevant un signal S, un module 620 de transformée inverse ($MDCT^{-1}$), un module 630 de reconstruction du signal par addition/recouvrement (add/rec) comme décrit en référence à la figure 1 et délivrant un signal reconstruit $x_{rec}(n)$ au dispositif de traitement d'atténuation selon l'invention. On peut noter qu'on prend ici l'exemple de la transformée MDCT qui est la plus courante en codage de parole et audio, cependant le dispositif 600 s'applique également à tout autre type de transformée (FFT, DCT, etc.).

En sortie du dispositif 600, un signal traité Sa est fourni dans lequel une atténuation de pré-écho a été effectuée.

Le dispositif 600 met en oeuvre une méthode d'atténuation des pré-échos dans le signal décodé $x_{rec}(n)$ qui est décomposé en sous signaux - cette décomposition est propre au traitement des pré-échos.

Dans un mode de réalisation de l'invention, le procédé de traitement d'atténuation comporte une étape de détection (E601) des attaques qui peuvent engendrer un pré-écho, dans le signal décodé $x_{rec}(n)$. On peut noter que le dispositif d'atténuation 600 peut être appliqué aussi bien dans les cas où le fenêtrage MDCT de synthèse est fixe que dans ceux où le fenêtrage est adaptatif.

Ainsi, le dispositif 600 comporte un module de détection 601 apte à mettre en oeuvre une étape de détection (E601) de la position d'une attaque dans un signal audio décodé.

Une attaque (ou *onset* en anglais) est une transition rapide et une variation brusque de la dynamique (ou amplitude) du signal. On peut désigner ce type de signaux par le terme plus général de "transitoire". Dans la suite et sans perte de généralité, on utilisera uniquement les termes d'attaque ou de transition pour désigner également des transitoires.

Dans ce mode de réalisation, illustré par les flèches en traits mixtes "a", la détection de pré-écho est réalisée sur le signal décodé avant l'étape de décomposition (E603) en sous-signaux du module 603 décrit ultérieurement.

Chaque trame courante de L échantillons du signal décodé $x_{rec}(n)$ est divisée en K sous-blocs de longueur L', avec par exemple L = 640 échantillons (20 ms) à 32 kHz, L' = 80 échantillons (2.5 ms) et K = 8. De préférence la taille de ces sous-blocs est donc identique mais l'invention reste valable et facilement généralisable quand les sous-blocs ont une taille variable. Cela peut être le cas par exemple quand la longueur de la trame L n'est pas divisible par le nombre de sous-blocs K ou si la longueur de trame est variable.

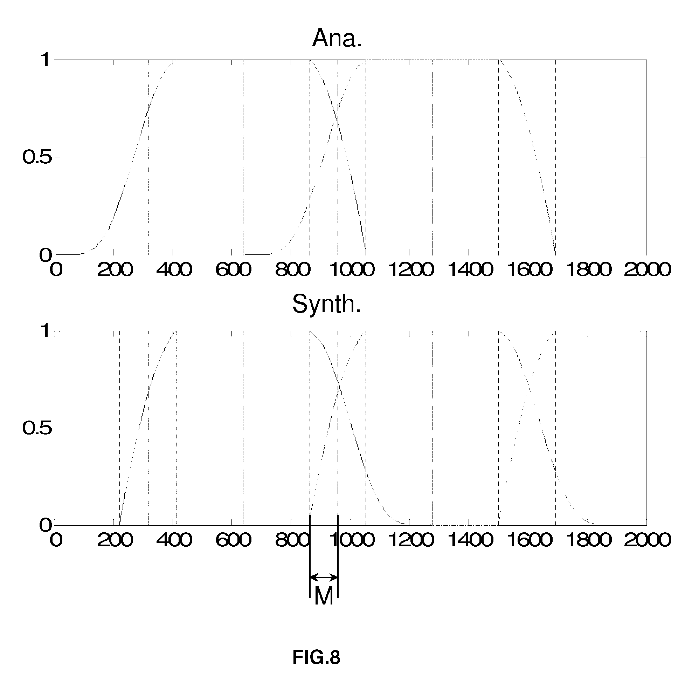

Des fenêtres d'analyse-synthèse spéciales à bas retard similaires à celles décrites dans la norme UIT-T G.718 sont utilisées pour la partie analyse et pour la partie synthèse de la transformation MDCT. Un exemple de telles fenêtres est illustré en référence à la figure 8. Le retard engendré par la transformation est de seulement 192 échantillons contrairement au retard de 640 échantillons dans le cas d'utilisation des fenêtres sinusoïdales classiques. Ainsi la mémoire MDCT avec des fenêtres d'analyse-synthèse spéciales à bas retard ne contient que 96 échantillons indépendants (non repliés avec la trame actuelle) contrairement aux 320 échantillons dans le cas d'utilisation des fenêtres sinusoïdales classiques.

On peut en effet remarquer sur la **figure 8** pour les fenêtres d'analyses (Ana.), que la zone de repliement est limitée par les traits en pointillés entre les échantillons 864 et 1055. La ligne de repliement est représentée en trait mixte à l'échantillon 960.

Pour la synthèse (Synth.), seuls les échantillons représentés par l'intervalle M (96 échantillons) sont nécessaires pour obtenir l'information sur la zone de repliement de l'analyse, en exploitant la symétrie. Ces échantillons contenus en mémoire sont alors utiles pour décoder cette zone de repliement en utilisant également les échantillons repliés de la fenêtre de la trame suivante. Dans le cas d'une attaque dans cette zone entre les échantillons 864 et 1055 l'énergie moyenne des échantillons représentés par l'intervalle M est nettement supérieure à l'énergie de sous-trames précédant l'échantillon 864. L'augmentation brusque de l'énergie de l'intervalle M contenue dans la mémoire MDCT peut donc signaler une attaque dans la trame suivante qui peut engendrer un pré-écho dans la trame courante.

Dans une variante de ce mode de réalisation, d'autres fenêtres d'analyse/synthèse peuvent être utilisées, ou des commutations entre fenêtres longues et courtes peuvent être utilisées.

On utilise la mémoire MDCT $x_{MDCT}(n)$ qui donne une version avec repliement temporel ("folding" en anglais) du signal futur. Cette mémoire ou une partie de cette mémoire (à cause des redondances) est aussi divisée en K' sous-blocs de longueur $L_m(n)$, n = 0, .., K' où $L_m(n)$ est comparable mais pas forcément identique à L'. Dans le cas d'utilisation des fenêtres sinusoïdales classiques, on ne retient que les K'=4 premiers sous-blocs de longueur $L_m(n)=L'=80$ du signal $x_{MDCT}(n)$ car les 4 derniers sous-blocs sont symétriques par rapport aux 4 premiers sous-blocs et ne portent ainsi aucune information supplémentaire pour la détection d'une attaque dans la trame suivante. Par contre, si on utilise des fenêtres d'analyse-synthèse spéciales à bas retard comme illustrées en figure 8, on ne retient qu'un (K'=1) bloc de longueur $L_m(0)=96$ qui contient tous les échantillons indépendants de la mémoire MDCT. Malgré le nombre d'échantillons supérieur dans ce sous-bloc, son énergie reste comparable avec celle des sous-blocs de la trame courante car la partie mémoire a été fenêtré (donc atténuée) par la fenêtre d'analyse. On peut remarquer que le nombre d'échantillons est de 96 (au lieu de 80) et que le fenêtrage pourrait être compensé ; l'invention s'applique pareillement dans le cas où une telle compensation est mise en oeuvre.

En effet, la figure 1 montre que le pré-écho influence la trame qui précède la trame où se situe l'attaque, et il est souhaitable de détecter une attaque dans la trame future qui est en partie contenue dans la mémoire MDCT. On peut noter que le signal contenu dans la mémoire MDCT inclut un repliement temporel (qui est compensé lorsque la trame suivante est reçue). Comme expliqué ci-dessous, le signal $x_{MDCT}(n)$ dans la mémoire MDCT sert ici essentiellement à estimer l'énergie par sous-blocs du signal dans la trame suivante (future) et on considère que cette estimation est suffisamment précise pour les besoins de la détection et de l'atténuation de pré-écho lorsqu'elle est réalisée à partir de la mémoire MDCT disponible à la trame courante au lieu du signal complètement décodé à la trame future.

La trame courante et la mémoire MDCT peuvent être vues comme des signaux concaténés formant un signal découpé en (K+K') sous-blocs consécutifs. Dans ces conditions, on définit l'énergie dans le k-ième sous-bloc comme :

$$En(k) = \sum_{n=kL'}^{(k+1)L'-1} x_{rec}(n)^2, \; k = 0,...,K-1$$

quand le k-ième sous-bloc se situe dans la trame courante et, comme:

$$En(k) = \sum_{n=L_{cm}(k-K)}^{L_{cm}(k-K+1)-1} x_{MDCT}(n)^2, \; k = K,...,K+K'-1$$

quand le sous-bloc est dans la mémoire MDCT (qui représente le signal disponible pour la trame future) et $L_{cm}(i)$ contient les frontières de sous-blocs de la partie mémoire :

$$L_{cm}(i) = \begin{cases} 0 \text{ si } i = 0 \\ \sum_{k=0}^{i-1} L_m(k) \text{ si } i > 0 \end{cases}$$

L'énergie moyenne des sous-blocs dans la trame courante s'obtient donc comme :

$$\overline{En} = \frac{1}{K} \sum_{k=0}^{K-1} En(k)$$

On définit également l'énergie moyenne des sous-blocs dans la deuxième partie de la trame courante comme (supposant que K est un nombre pair):

$$\overline{En}' = \frac{2}{K} \sum_{k=K/2}^{K-1} En(k)$$

Une attaque associée à un pré-écho est détectée si le rapport $R(k) = \dfrac{\max\limits_{n=0,K+K'-1}(En(n))}{En(k)}$ dépasse un seuil prédéfini, dans un des sous-blocs considérés. D'autres critères de détection de pré-écho sont possibles sans changer la nature de l'invention.

Par ailleurs, on considère que la position de l'attaque est définie comme

$$pos = \min\left( L'.\left( arg \max_{k=0,K+K'-1}(En(k)) \right), L \right)$$

où la limitation à L assure que la mémoire MDCT n'est jamais modifiée. D'autres méthodes d'estimation plus précise de la position de l'attaque sont également possibles.

Dans des variantes de réalisation avec commutation des fenêtres - autrement dit avec un fenêtrage MDCT adaptatif -, d'autres méthodes donnant la position de l'attaque peuvent être utilisées avec une précision allant de l'échelle d'un sous-bloc jusqu'à une position à l'échantillon près.

Dans l'exemple donné ci-dessus la détection des attaques qui peuvent engendrer un pré-écho est faite sur le signal décodé, commun pour tous les sous-signaux. Dans une variante de réalisation, cette détection peut être faite séparément dans les sous-signaux obtenus suite à l'étape E603 décrite ultérieurement. Ce cas est illustré par les flèches en traits pointillés "b".

Le dispositif 600 comporte également un module 602 de détermination mettant en oeuvre une étape de détermination (E602) d'une zone de pré-écho (ZPE) précédant la position d'attaque détectée. On appelle ici zone de pré-écho la zone couvrant les échantillons avant la position estimée de l'attaque qui sont perturbés par le pré-écho engendré par l'attaque et où l'atténuation de ce pré-écho est souhaitable. Selon l'invention, la zone de pré-écho peut être déterminée sur le signal décodé (flèches a de la figure 6). Dans une variante de réalisation, elle peut être déterminée séparément pour chaque sous- signal.

Dans cette variante de réalisation, la zone de pré-écho est déterminée indépendamment pour les sous-signaux obtenus par l'étape E603 décrite ultérieurement, selon le mode de réalisation décrit par les flèches b de la figure 6. Ainsi la zone de pré-écho peut être différente pour les différents sous-signaux.

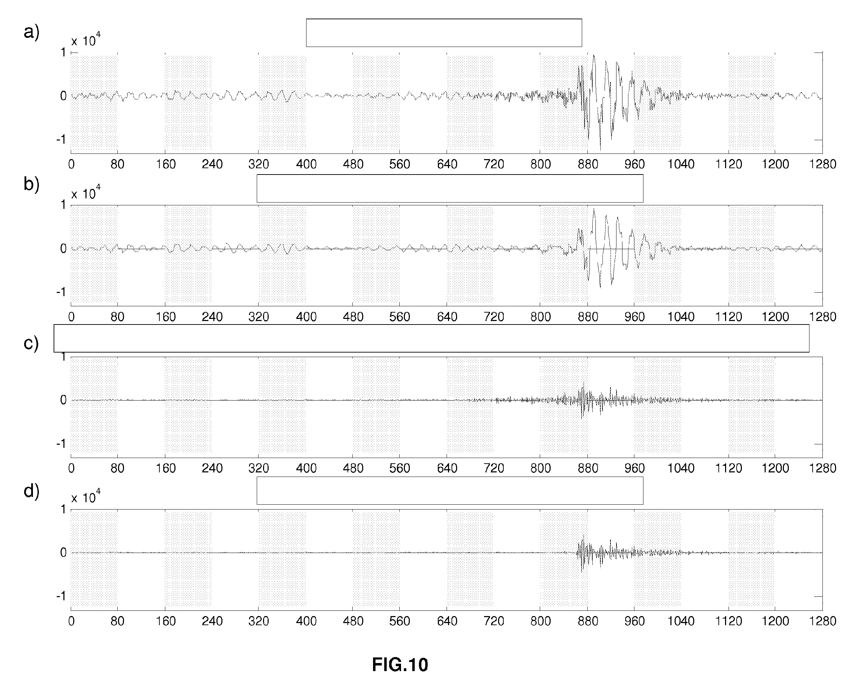

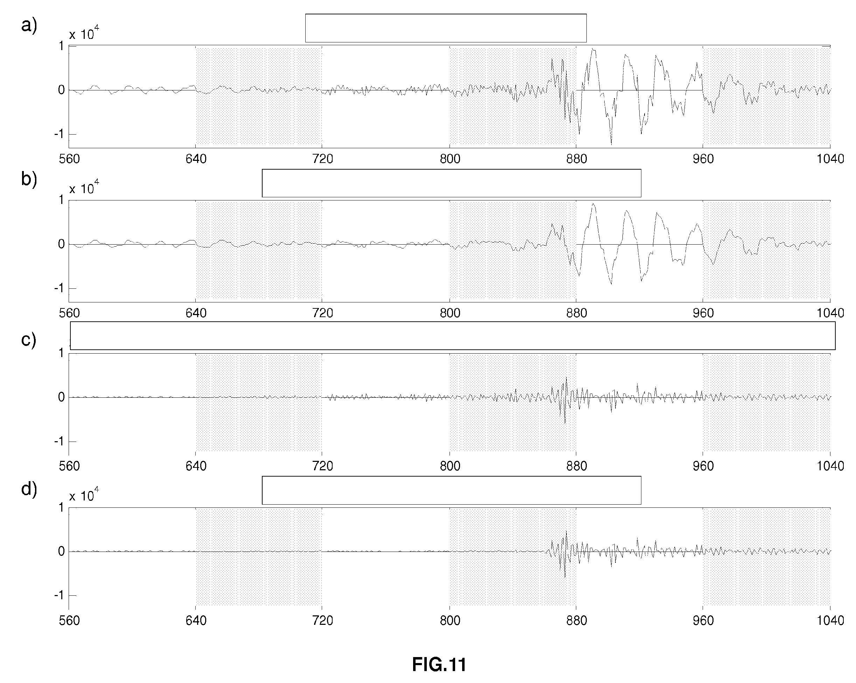

Cette différence est illustrée par exemple sur les **figures 10 et 11** qui représentent en a) un exemple de signal décodé (avant atténuation de pré-écho), en b), un premier sous-signal avec des composantes majoritairement basses fréquences (sans atténuation de pré-écho), en c), un deuxième sous-signal avec des composantes majoritairement hautes fréquences (sans atténuation de pré-écho) et en d), le deuxième sous-signal après atténuation de pré-écho selon l'invention. La figure 11 reprend les mêmes signaux mais avec un zoom sur les échantillons allant de 560 à 1040.

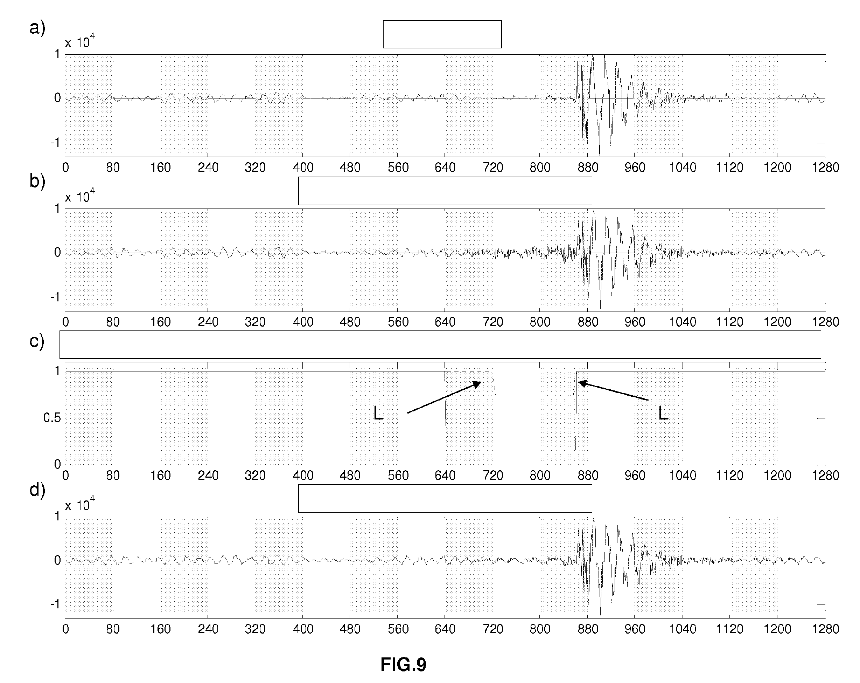

On peut remarquer sur ces figures que le pré-écho est plus important sur le deuxième sous-signal que sur le premier. La zone de pré-écho des deux sous-signaux illustrés ici, est donc bien différente. Comme résultat de cela, sur la figure 9 c) qui illustre les gains d'atténuation obtenus pour les deux sous-signaux, on peut observer que les gains d'atténuation (en pointillé pour le premier sous-signal et en trait plein pour le deuxième) sont tels que pour le deuxième sous-signal avec des composantes hautes fréquences, plus d'échantillons sont atténués (échantillons 640 à 860) que pour le premier sous-signal avec des composantes basses fréquences (échantillons 720 à 860).

Dans un mode de réalisation d'obtention des zones de pré-échos, les énergies $En(k)$ sont concaténées en ordre chronologique, avec d'abord l'enveloppe temporelle du signal décodé, puis l'enveloppe du signal de la trame suivante estimée à partir de la mémoire de la transformée MDCT. En fonction de cette enveloppe temporelle concaténée et des énergies moyennes $\overline{En}$ et $\overline{En}'$ de la trame précédente, la présence de pré-écho est détectée par exemple si le rapport R(k) dépasse un seuil, typiquement ce seuil est 32.

Les sous-blocs dans lequel un pré-écho a été détecté constituent ainsi une zone de pré-écho, qui en général couvre les échantillons $n = 0,\cdots, pos$ -1, soit du début de la trame courante à la position de l'attaque (*pos*).

Dans des variantes de réalisation, la zone de pré-écho ne commence pas nécessairement au début de la trame, et peut faire intervenir une estimation de la longueur du pré-écho. Si une commutation de fenêtres est utilisée, la zone de pré-écho devra être définie pour prendre en compte les fenêtres utilisées. On peut aussi noter que la zone de pré-écho peut très bien s'étendre sur toute la trame courante si l'attaque a été détectée dans la trame future.

Le dispositif 600 comporte un module 603 de décomposition du signal, apte à effectuer une étape E603 de décomposition du signal décodé en au moins deux sous-signaux selon un critère prédéterminé.

Ce critère peut par exemple être un critère fréquentiel permettant ainsi d'obtenir des sous-signaux avec des composantes fréquentielles différentes comme illustrés sur les figures 10 et 11 décrites précédemment.

Le critère peut par exemple être un critère de périodicité du signal donnant ainsi des sous-signaux avec des composantes représentatives de la périodicité du signal ou au contraire de son bruit.

Dans une réalisation particulière de l'invention, le signal décodé $x_{rec}(n)$ est décomposé à l'étape E603 en deux sous-signaux de la manière suivante :

- le premier sous-signal $g_{rec,ss1}(n)$ est obtenu par filtrage passe bas en utilisant un filtre FIR (filtre à réponse impulsionnelle finie) à 3 coefficients et à phase nulle de fonction de transfert $c(n)z^{-1}+(1-2c(n))+c(n)z$ avec $c(n)$ une valeur comprise entre 0 et 0.25, où $[c(n),1-2c(n),c(n)]$ sont les coefficients du filtre passe bas ; ce filtre est mis en oeuvre avec l'équation aux différences :

$$x_{rec,ss1}\left(n\right) = c(n)x_{rec}(n-1) + \left(1-2c(n)\right)x_{rec}(n) + c(n)x(n+1)$$

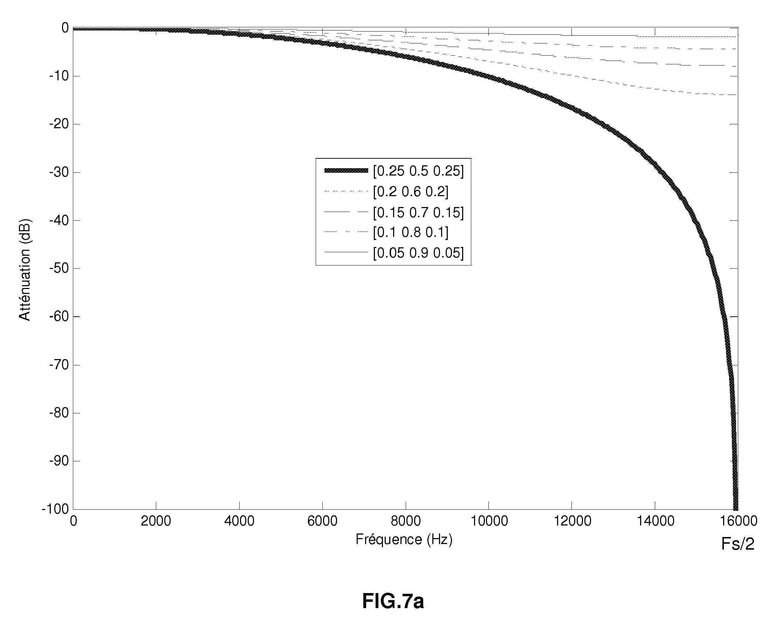

Dans un mode particulier de réalisation, on utilise une valeur constante $c(n) = 0.25$. La réponse fréquentielle de ce filtre est illustrée à la **figure 7a**, en fonction des coefficients

$$\left[c(n),1-2c(n),c(n)\right], \text{ pour c(n)} = 0.05, 0.1, 0.15, 0.2 \text{ et } 0.25.$$

On peut remarquer que le sous signal $x_{rec,ss1}(n)$ résultant de ce filtrage, contient donc des composantes plutôt basses fréquences du signal décodé.

- le deuxième sous signal $x_{rec,ss2}(n)$ est obtenu par filtrage passe haut complémentaire en utilisant un filtre FIR à 3 coefficients et à phase nulle de fonction de transfert $-c(n)z^{-1}+2c(n)-c(n)z$, où $[-c(n), 2c(n),-c(n)]$ sont les coefficients du filtre passe haut ; ce filtre est mis en oeuvre avec l'équation aux différences :

$$x_{rec,ss2}\left(n\right) = -c(n)x_{rec}(n-1) + 2c(n)x_{rec}(n) - c(n)x(n+1)$$

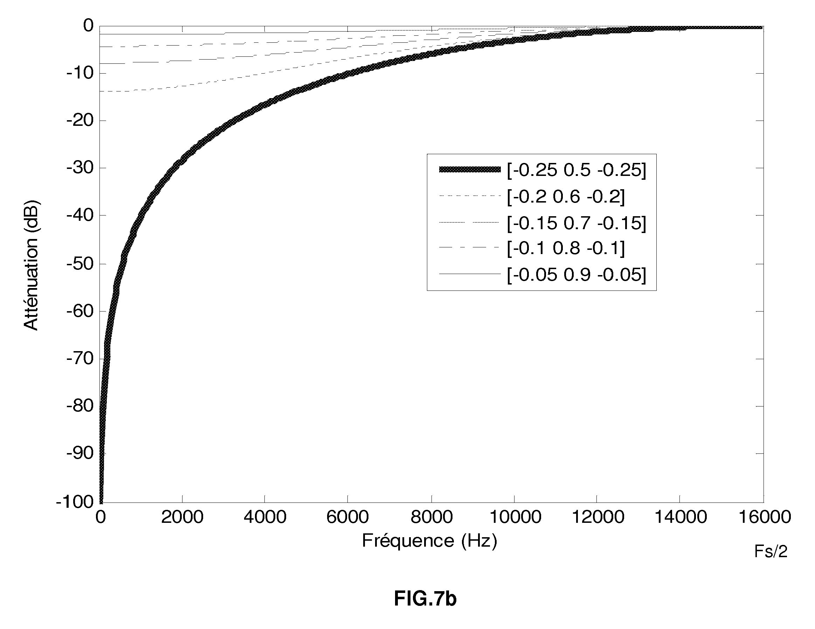

La réponse fréquentielle de ce filtre est illustrée sur la **figure 7b,** en fonction des coefficients [-*c*(*n*),2*c*(*n*),-*c*(*n*)], pour c(n) = 0.05, 0.1, 0.15, 0.2 et 0.25. Le sous signal $x_{rec,ss2}(n)$ résultant de ce filtrage, contient donc des composantes plutôt hautes fréquences du signal décodé.

La motivation pour utiliser ces filtres est leur très faible complexité de mise en oeuvre (en termes de nombre de calculs par échantillon), leur phase nulle et le faible retard associé (1 échantillon) - à noter que ces filtres sont en fait utilisés sans retard, du fait que le signal futur ("lookahead" en anglais) est réduit à un échantillon et qu'il est prédit à partir du signal décodé, cette prédiction étant décrite plus loin. Leurs réponses fréquentielles correspondent bien aux caractéristiques de filtres passe-bas et passe haut et permettent de décomposer le signal en 2 sous-signaux selon leur contenu fréquentiel. A noter que

$$x_{rec,ss1}(n) + x_{rec,ss2}(n) = x_{rec}(n)$$

Il est donc également possible d'obtenir $x_{rec,ss2}(n)$ en soustrayant $x_{rec,ss1}(n)$ de $x_{rec}(n)$ ce qui réduit la complexité des calculs : $x_{rec,ss2}(n)=x_{rec}(n)-x_{rec,ss}1(n)$

Dans les deux cas, la combinaison des sous-signaux atténués pour l'obtention du signal atténué est faite par simple addition des sous-signaux atténués à l'étape E606 décrite ultérieurement.

Pour ne pas utiliser de signal futur pour ces filtrages, on peut par exemple compléter le signal décodé par un échantillon à 0 à la fin du bloc. D'autres valeurs sont possibles pour compléter (prédire) le signal futur : par exemple on pourrait répéter le dernier échantillon (la dernière valeur du bloc) ou prédire l'échantillon futur, par exemple par simple extrapolation linéaire. Dans le cas du signal décodé complété par un échantillon à 0 à la fin du bloc pour n=L-1 le sous signal $x_{rec,ss1}(n)$ est obtenu par :

$$x_{rec,ss1}(L-1) = c(L-1)x_{rec}(L-2) + (1-2c(L-1))x_{rec}(L-1),$$

$x_{rec,ss2}(n)$ est toujours calculé comme $x_{rec,ss2}(n)=x_{rec}(n)-x_{rec,ss}1(n)$.

On peut noter que les deux sous-signaux restent ici à la même fréquence d'échantillonnage que le signal décodé. Dans des variantes du mode de réalisation on pourra étendre l'ordre des filtres passe-bas et passe-haut, par exemple en passant à l'ordre 4 (au lieu de 2), tout en gardant leurs caractéristiques de phase nulle.

Une étape E604 de calcul de facteurs d'atténuation de pré-écho est mise en oeuvre dans le module de calcul 604. Ce calcul est fait séparément pour les deux sous signaux.

Ces facteurs d'atténuation sont obtenus par échantillon de la zone de pré-écho déterminée en fonction de la trame dans laquelle l'attaque a été détectée et de la trame précédente.

On obtient alors les facteurs $g_{pre,ss1}'(n)$ et $g_{pre,ss2}'(n)$ où n est l'indice de l'échantillon correspondant. Ces facteurs seront éventuellement lissés pour obtenir les facteurs $g_{pre,ss1}(n)$ et $g_{pre,ss2}(n)$ respectivement. Ce lissage est surtout important pour les sous signaux contenant les composantes basse-fréquence (donc pour $g_{pre,ss1}(n)$ dans cet exemple).

Pour des raisons de simplicité nous détaillons ici l'exemple de la décomposition en deux sous-signaux du signal décodé par filtrage FIR à 3 coefficients, où ces deux sous-signaux contiennent respectivement les composantes majoritairement basses fréquences et hautes fréquences du signal décodé.

Ainsi le facteur d'atténuation peut être choisi totalement indépendamment pour les sous signaux et le niveau d'atténuation peut être précisément réglé, en fonction du passé et du futur de chaque sous-signal.

Un exemple de réalisation de calcul d'atténuation est décrit dans la demande de brevet FR 08 56248. Les facteurs d'atténuations sont calculés par sous-bloc. Dans le procédé décrit ici, ils sont en plus calculés séparément pour chaque sous signal. Pour les échantillons précédent l'attaque détectée, on calcule donc les facteurs d'atténuation $g_{pre,ss1}(n)$ et $g_{pre,ss2}'(n)$. Ensuite ces valeurs d'atténuations sont éventuellement lissées pour obtenir les valeurs d'atténuation par échantillon.

Le calcul du facteur d'atténuation d'un sous-signal (par exemple $g_{pre,ss2}'(n)$) peut être similaire à celui décrit dans la demande de brevet FR 08 56248 pour le signal décodé en fonction du rapport R(k) (utilisé également pour la détection de l'attaque) entre l'énergie du sous-bloc de plus forte énergie et l'énergie du k-ième sous-bloc du signal décodé. On initialise $g_{pre,ss2}'(n)$ comme :

$$g_{pre,ss2}'(n) = g(k) = f(R(k)), n = kL',...,(k+1)L'-1; k = 0,...,K-1$$

où *f* est une fonction décroissante à valeurs entre 0 et 1. D'autres définitions du facteur *g(k)* sont possibles, par exemple en fonction de *En(k)* et de *En(k-1)*.

Si la variation de l'énergie par rapport à l'énergie maximale est faible, aucune atténuation n'est alors nécessaire. Le facteur est alors fixé à une valeur d'atténuation inhibant l'atténuation, c'est-à-dire 1. Sinon, le facteur d'atténuation est compris entre 0 et 1. Cette initialisation peut être commune pour tous les sous-signaux.

Dans une variante de réalisation, l'initialisation peut être différente pour les sous signaux.

Dans une autre variante de réalisation, au lieu d'utiliser le même rapport *R(k)* pour la détection de l'attaque et le traitement dans le domaine du signal décodé, on peut recalculer le même type de rapport sur le sous-signal en question.

Dans encore une autre variante de réalisation *f(R(k))* peut être constant pour toute la zone pré-écho, par exemple *f(R(k))* = 0.01

Les valeurs d'atténuation sont ensuite affinées par sous-signal pour pouvoir régler le niveau d'atténuation optimal par sous-signal en fonction des caractéristiques du signal décodé. Par exemple les atténuations peuvent être limitées en fonction de l'énergie moyenne du sous-signal de la trame précédente car il n'est pas souhaitable qu'après le traitement d'atténuation de pré-écho, l'énergie du signal devienne inférieure à l'énergie moyenne par sous-bloc du signal précédant la zone de traitement (typiquement celle de la trame précédente ou celle de la deuxième moitié de la trame précédente).

Cette limitation peut être faite de façon similaire à celle décrite dans la demande de brevet FR 08 56248. Par exemple pour le deuxième sous-signal $x_{rec,ss2}(n)$ on calcule d'abord l'énergie dans les K sous-bloc de la trame courante comme :

$$En_{ss2}(k) = \sum_{n=kL'}^{(k+1)L'-1} x_{rec,ss2}(n)^2, \; k = 0,...,K-1$$

On connait également par mémorisation l'énergie moyenne de la trame précédente $\overline{En_{ss2}}$ et celle de la deuxième moitié de la trame précédente $\overline{En_{ss2}}'$ qui peuvent être calculés (à la trame précédente) comme :

$$\overline{En_{ss2}} = \frac{1}{K}\sum_{k=0}^{K-1} En_{ss2}(k)$$

et

$$\overline{En_{ss2}}' = \frac{2}{K}\sum_{k=K/2}^{K-1} En_{ss2}(k)$$

où les indices de sous-bloc de 0 à K correspondent à la trame courante.

Pour le sous-bloc k à traiter on peut calculer la valeur limite du facteur $\lim_{g,ss2}(k)$ afin d'obtenir exactement la même énergie que l'énergie moyenne par sous-bloc du segment précédant le sous-bloc à traiter. Cette valeur est bien sûr limitée à un maximum de 1 puisqu'on s'intéresse ici aux valeurs d'atténuation. Plus précisément :

$$\lim_{g,ss2}(k) = \min\left(\sqrt{\frac{\max\left(\overline{En_{ss2}}, \overline{En_{ss2}}'\right)}{En_{ss2}(k)}}, 1\right)$$

où l'énergie moyenne du segment précédent est approximée par max $(\overline{En_{ss2}}, \overline{En_{ss2}}')$.

La valeur $\lim_{g,ss2}(k)$ ainsi obtenue sert de limite inférieure dans le calcul final du facteur d'atténuation du sous-bloc :

$$g_{pre,ss2}'(n) = \max\left(g_{pre,ss2}'(n), \lim_{g,ss2}(k)\right), n = kL',...,(k+1)L'-1; k = 0,...,K-1$$

Dans une première variante de réalisation la zone de pré-écho où l'atténuation s'étend du début de la trame courante jusqu'au début du sous-bloc dans lequel l'attaque a été détecté - jusqu'à l'indice *pos* où

$$pos = \min\left( L'.\left( arg \max_{k=0,K+K'-1}\left( En\left(k\right)\right)\right), L\right)$$. Les atténuations associées aux échantillons du sous-bloc de l'attaque sont toutes mises à 1 même si l'attaque se situe vers la fin de ce sous-bloc.

Dans une autre variante de réalisation la position de début de l'attaque *pos* est affinée dans le sous-bloc de l'attaque, par exemple en découpant le sous-bloc en sous-sous-blocs et en observant l'évolution de l'énergie de ces sous-sous-blocs. Supposons que la position du début de l'attaque est détectée dans le sous-bloc k, k>0 et le début de l'attaque raffiné *pos* se trouve dans ce sous-bloc, les valeurs d'atténuation pour les échantillons de ce sous-bloc qui se trouvent avant l'indice *pos* peuvent être initialisées en fonction de la valeur d'atténuation correspondant au dernier échantillon du sous-bloc précédent :

$$g_{pre,ss2}'(n) = g_{pre,ss2}'(kL'-1), n = kL',..., pos-1$$

Toutes les atténuations à partir de l'indice *pos* sont mises à 1.

Pour le premier sous-signal contenant les composantes basses fréquences du signal décodé, le calcul des valeurs d'atténuation en se basant sur le sous-signal $x_{rec,ss1}(n)$ peut être similaire au calcul des valeurs d'atténuation en se basant sur le signal décodé $x_{rec}(n)$. Ainsi, dans une variante de réalisation, par souci de réduction de complexité de calcul, les valeurs d'atténuation peuvent être déterminées en se basant sur le signal décodé $x_{rec}(n)$. Dans le cas où la détection des attaques est faite sur le signal décodé il n'est donc plus nécessaire de recalculer des énergies des sous-blocs car pour ce signal les valeurs d'énergie par sous-bloc sont déjà calculées pour détecter les attaques. Comme pour la grande majorité des signaux les basses fréquences sont beaucoup plus énergétiques que les hautes fréquences, les énergies par sous-bloc du signal décodé $x_{rec}(n)$ et du sous signal $x_{rec,ss1}(n)$ sont très proches, cette approximation donne un résultat très satisfaisant. Ceci peut être observé sur les figures 10 et 11 où l'amplitude du signal décodé en a) et du sous signal comportant majoritairement des composantes basses fréquences en b) sont très proches, contrairement à celle du sous-signal comportant majoritairement des composantes hautes fréquences en c) beaucoup moins énergétique. Ainsi dans cette variante, pour au moins un sous-signal, le calcul du facteur d'atténuation s'effectue en utilisant au moins un paramètre de l'étape de détection d'une position d'attaque dans le signal décodé, ce qui réduit encore la complexité.

Les facteurs d'atténuation $g_{pre,ss1}(n)$ et $g_{pre,ss2}(n)$ déterminés par sous-blocs peuvent être ensuite lissés par une fonction de lissage appliquée échantillon par échantillon pour éviter des variations brusques du facteur d'atténuation aux frontières des blocs. Ceci est particulièrement important pour les sous-signaux contenant des composantes basses fréquences comme le sous-signal $x_{rec,ss1}(n)$ mais pas nécessaire pour les sous-signaux ne contenant que des composantes hautes fréquences comme le sous signal $x_{rec,ss2}(n)$.

La **figure 9** illustre un exemple d'application d'un gain d'atténuation avec des fonctions de lissage représentées par les flèches L.

Cette figure illustre en a), un exemple de signal original, en b), le signal décodé sans atténuation de pré-écho, en c), les gains d'atténuation pour les deux sous-signaux obtenus selon le procédé de l'invention à l'étape de décomposition et en d), le signal décodé avec atténuation d'écho selon l'invention (c'est-à-dire après combinaison des deux sous-signaux atténués).

On peut remarquer sur cette figure que le gain d'atténuation représenté en trait pointillé et correspondant au gain calculé pour le premier sous-signal comportant des composantes basses fréquences, comporte des fonctions de lissage comme décrit ci-dessus. Le gain d'atténuation représenté en trait plein et calculé pour le deuxième sous-signal comportant des composantes hautes fréquences, ne comporte pas de gain de lissage.

Le signal représenté en d) montre bien que le pré-écho a été atténué de façon efficace par le procédé selon l'invention.

La fonction de lissage est par exemple définie de préférence par les équations suivantes:

$$g_{pre,ss1}\left(n\right) = \frac{1}{u}\sum_{i=0}^{u-1} g_{pre,ss1}'\left(n-i\right), \quad n = 0,\cdots,L-1$$

avec la convention que $g_{pre,ss1}'\left(n\right) n = -(u-1),\cdots,-1$ sont les derniers u-1 facteurs d'atténuation obtenus pour les derniers échantillons du sous-bloc précédent du sous-signal $x_{rec,ss1}(n)$. Typiquement u = 5 mais une autre valeur pourrait être utilisée. En fonction du lissage utilisé, la zone de pré-écho (le nombre des échantillons atténués) peut donc être différente pour les 2 sous-signaux traités séparément, même si la détection de l'attaque est faite en commun sur la base du signal décodé.

Le facteur d'atténuation lissé ne remonte pas à 1 au moment de l'attaque, ce qui implique une diminution de l'amplitude de l'attaque. L'impact perceptible de cette diminution est très faible mais doit néanmoins être évité. Pour pallier à ce problème la valeur de facteur d'atténuation peut être forcée à 1 pour les u-1 échantillons précédant l'indice *pos* où se situe le début de l'attaque. Ceci est équivalent à avancer le marqueur *pos* de u-1 échantillons pour le sous signal où le lissage est appliqué. Ainsi la fonction de lissage accroît progressivement le facteur pour avoir une valeur 1 au moment de l'attaque. L'amplitude de l'attaque est alors préservée.

D'autres fonctions de lissage sont possibles, par exemple :

$$g_{pre,ss1}(n) = \alpha g_{pre,ss1}(n-1) + (1-\alpha) g_{pre,ss1}'(n)$$

avec typiquement $\alpha=0.85$.

Si le lissage n'est pas appliqué :

$$g_{pre,ss2}(n) = g_{pre,ss2}'(n)$$

Le module 605 du dispositif 600 de la figure 6 met en oeuvre l'étape E605 d'atténuation de pré-écho dans la zone de pré-écho de chacun des sous-signaux par application aux sous-signaux des facteurs d'atténuation ainsi calculés.

L'atténuation de pré-écho est donc faite de façon indépendante dans les sous signaux. Ainsi, dans les sous signaux représentants différentes bandes de fréquence, l'atténuation peut être choisie en fonction de la répartition spectrale du pré-écho.

Enfin, une étape E606 du module d'obtention 606 permet d'obtenir le signal de sortie atténué (le signal décodé après atténuation de pré-écho) par combinaison (dans cet exemple par simple addition) des sous-signaux atténués, selon l'équation:

$$x_{rec,f}(n) = g_{pre,ss1}(n)x_{rec,ss1}(n) + g_{pre,ss2}(n)x_{rec,ss2}(n), \ n = 0, \cdots, L-1$$

Contrairement à une décomposition en sous-bandes classique, on peut noter ici que les filtrages utilisés ne sont pas associés à des opérations de décimation des sous-signaux et la complexité et le retard ("lookahead" ou trame future) sont réduits au minimum.

D'autres exemples de décomposition du signal décodé peuvent bien évidemment être appliqués dans le cadre de cette invention.

Par exemple, la décomposition du signal décodé peut s'effectuer en utilisant des bancs de filtres à décimation critique, par exemple de type QMF (pour "Quadrature Mirror Filter" en anglais), PQMF (pour "Pseudo Quadrature Mirror Filter" en anglais), pour obtenir des signaux en sous bandes, ces signaux en sous-bandes ayant une fréquence d'échantillonnage inférieure à celle du signal décodé.

Une fois que l'atténuation de pré-écho est faite dans les sous-bandes, le signal de sortie est obtenu par filtrage QMF de synthèse.

Le signal décodé à traiter peut être décomposé en plusieurs sous-signaux, par exemple en utilisant un filtre QMF ou PQMF à 4 sous-bandes. Cette approche a cependant l'inconvénient d'être plus complexe et d'occasionner un retard de plusieurs échantillons.

Ainsi, plus généralement, la décomposition peut permettre d'obtenir plus de deux sous-signaux.

De plus, la décomposition peut être effectuée selon un critère différent du critère fréquentiel.

Un critère du type périodicité du signal peut par exemple être utilisé. Dans cet exemple de critère, la décomposition du signal décodé donne ainsi un premier sous-signal avec des composantes sinusoïdales et un second sous-signal avec des composantes de type bruit lorsque le modèle de signal est de type sinus+bruit. Là encore, cette décomposition a l'inconvénient d'être plus complexe.

Quelque soit le critère de décomposition utilisé, la décomposition en sous-signaux, dans le cadre de cette invention, est appliquée spécifiquement pour le traitement des pré-échos sans qu'elle ne soit naturellement disponible au décodeur.

Ainsi, les facteurs d'atténuation calculés sont adaptés spécifiquement aux composantes des sous-signaux obtenus selon le critère de décomposition. Cela permet de rendre l'atténuation de pré-écho plus précise et mieux adaptée au signal.

L'utilisation d'un critère fréquentiel permet de contrôler précisément la quantité d'atténuation appliquée dans les différentes zones de fréquence et ainsi d'atténuer plus efficacement le pré-écho.

Ce résultat est notamment visible sur les figures 9 à 11 décrites précédemment où on peut voir que l'atténuation de pré-écho du signal (notamment du deuxième sous-signal) (représenté en d)) est effectuée de façon précise.

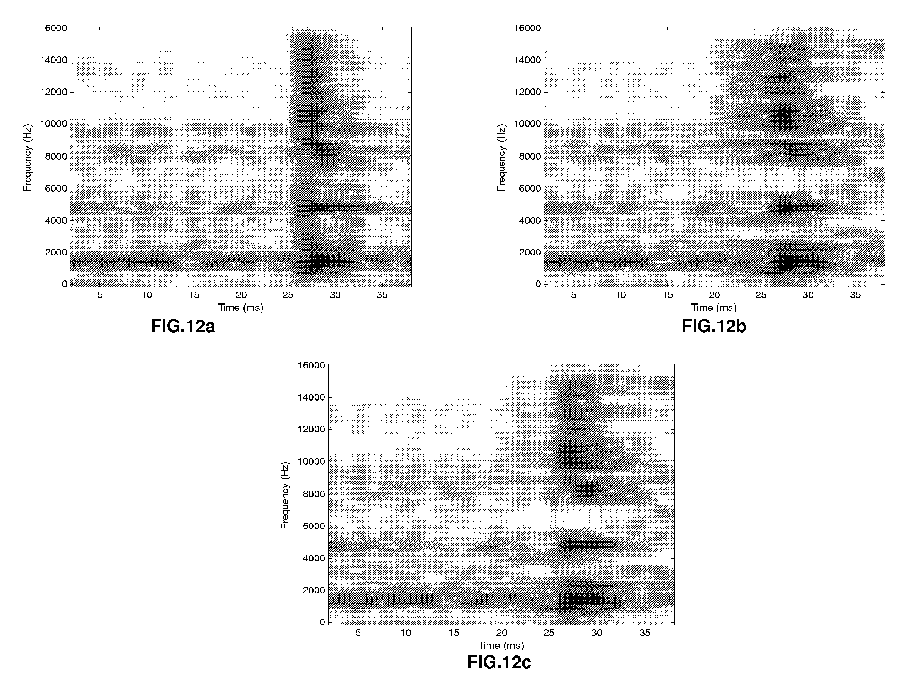

Les **figures 12a à 12c** montrent également ce résultat. En effet, la figure 12 a illustre le spectrogramme d'un signal original où on peut voir nettement l'attaque. La figure 12b illustre le signal décodé sans traitement d'atténuation de pré-écho. L'attaque n'est alors plus visible. La figure 12c illustre le spectrogramme du signal décodé avec le traitement d'atténuation de pré-écho selon l'invention. On peut à nouveau distinguer précisément l'attaque que ce soit dans la partie haute fréquence que basse fréquence.

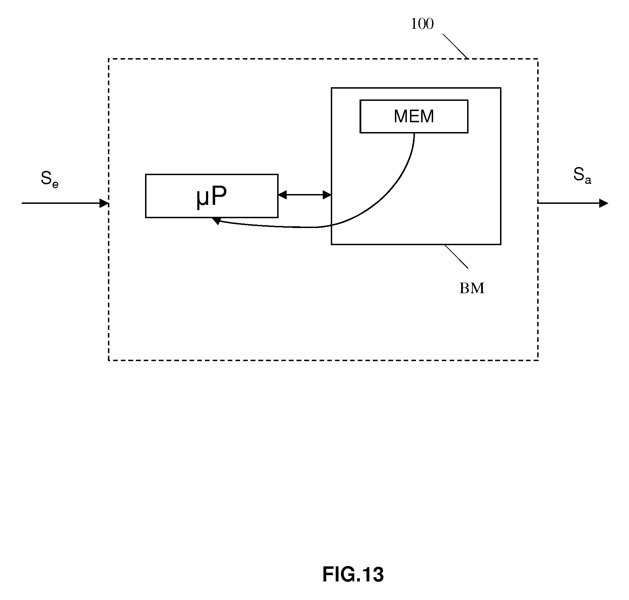

Un exemple de réalisation d'un dispositif de traitement d'atténuation selon l'invention est maintenant décrit en référence à la **figure 13.**

Matériellement, ce dispositif 100 au sens de l'invention comporte typiquement, un processeur μP coopérant avec un bloc mémoire BM incluant une mémoire de stockage et/ou de travail, ainsi qu'une mémoire tampon MEM précitée en tant que moyen pour mémoriser toutes données nécessaire à la mise en oeuvre du procédé de traitement d'atténuation tel que décrit en référence à la figure 6. Ce dispositif reçoit en entrée des trames successives du signal numérique Se et délivre le signal Sa reconstruit avec atténuation de pré-écho dans chacun des sous-signaux et reconstruction du signal atténué par combinaison des sous-signaux atténués.

Le bloc mémoire BM peut comporter un programme informatique comportant les instructions de code pour la mise en oeuvre des étapes du procédé selon l'invention lorsque ces instructions sont exécutées par un processeur μP du dispositif et notamment une étape de décomposition du signal décodé en au moins deux sous-signaux selon un critère de décomposition prédéterminé, de calcul de facteurs d'atténuation par sous-signal et par échantillon d'une zone de pré-écho préalablement déterminée, d'atténuation de pré-écho dans la zone de pré-écho de chacun des sous-signaux par application des facteurs d'atténuation aux sous-signaux et d'obtention du signal atténué par combinaison des sous-signaux atténués.

La figure 6 peut illustrer l'algorithme d'un tel programme informatique.

Ce dispositif d'atténuation selon l'invention peut être indépendant ou intégré dans un décodeur de signal numérique. Un tel décodeur peut être intégré à des équipements de stockage ou de transmission de signaux audionumériques tels que des passerelles de communication, des terminaux de communication ou des serveurs d'un réseau de communication.

**Revendications**

1. Procédé de traitement d'atténuation de pré-écho dans un signal audionumérique décodé selon un décodage par transformée, **caractérisé en ce qu'**il comporte les étapes suivantes:

   - décomposition (E603) du signal décodé en au moins deux sous-signaux selon un critère de décomposition prédéterminé;
   - calcul (E604) de facteurs d'atténuation par sous-signal et par échantillon d'une zone de pré-écho préalablement déterminée;
   - atténuation (E605) de pré-écho dans la zone de pré-écho de chacun des sous-signaux par application des facteurs d'atténuation aux sous-signaux; et
   - obtention (E606) du signal atténué par combinaison des sous-signaux atténués.

2. Procédé selon la revendication 1, **caractérisé en ce que** le critère de décomposition prédéterminé est un critère fréquentiel.

3. Procédé selon la revendication 2, **caractérisé en ce que** la décomposition du signal décodé s'effectue par un premier filtrage passe bas ou passe haut pour obtenir un premier sous-signal.

4. Procédé selon la revendication 3, **caractérisé en ce que** la décomposition du signal s'effectue en outre par un second filtrage passe haut ou passe bas, complémentaire au premier filtrage, pour obtenir un deuxième sous-signal.

5. Procédé selon la revendication 3, **caractérisé en ce que** un deuxième sous-signal est obtenu par soustraction du premier sous-signal au signal décodé.

6. Procédé selon la revendication 1, **caractérisé en ce que** la décomposition du signal décodé s'effectue par filtrage QMF et PQMF pour obtenir des sous-signaux en sous-bandes.

**7.** Procédé selon la revendication 1, **caractérisé en ce que** le critère de décomposition prédéterminé est un critère de périodicité du signal.

**8.** Procédé selon la revendication 1, **caractérisé en ce que** la zone de pré-écho est déterminée selon les étapes suivantes:

- détection d'une position d'attaque dans le signal décodé, avant l'étape de décomposition;
- détermination d'une zone de pré-écho précédant la position d'attaque détectée dans le signal décodé avant l'étape de décomposition ou dans les sous-signaux après l'étape de décomposition.

**9.** Procédé selon la revendication 1, **caractérisé en ce que** la zone de pré-écho est déterminée selon les étapes suivantes:

- détection d'une position d'attaque dans chacun des sous-signaux obtenus après l'étape de décomposition;
- détermination d'une zone de pré-écho précédant la position d'attaque détectée dans chacun des sous-signaux.

**10.** Procédé selon la revendication 8, **caractérisé en ce que** pour au moins un sous-signal, le calcul du facteur d'atténuation s'effectue en utilisant au moins un paramètre de l'étape de détection d'une position d'attaque dans le signal décodé.

**11.** Procédé selon la revendication 1, **caractérisé en ce qu'**une étape de lissage du facteur d'atténuation est appliquée pour au moins un sous-signal.

**12.** Procédé selon la revendication 1, **caractérisé en ce que** le facteur d'atténuation est forcé à 1 pour un nombre prédéterminé d'échantillons précédant le début de l'attaque.

**13.** Dispositif de traitement d'atténuation de pré-écho dans un signal audionumérique décodé à partir d'un décodeur par transformée, **caractérisé en ce qu'**il comprend:

- un module (603) de décomposition du signal décodé en au moins deux sous-signaux selon un critère de décomposition prédéterminé;
- un module (604) de calcul de facteurs d'atténuation par sous-signal et par échantillon d'une zone de pré-écho préalablement déterminée;
- un module (605) d'atténuation de pré-écho dans la zone de pré-écho de chacun des sous-signaux par application des facteurs d'atténuation aux sous-signaux;
- un module (606) d'obtention du signal atténué par addition des sous-signaux atténués.

**14.** Décodeur d'un signal audionumérique comportant un dispositif selon la revendication 11.

**15.** Programme informatique comportant des instructions de code pour la mise en oeuvre des étapes du procédé selon l'une des revendications 1 à 10, lorsque ces instructions sont exécutées par un processeur.

**Patentansprüche**

**1.** Verfahren zum Verarbeiten der Dämpfung eines Vorechos in einem digitalen Audiosignal, das gemäß einer Decodierung durch Transformierte decodiert wird, **dadurch gekennzeichnet, dass** es die folgenden Schritte umfasst:

- Zerlegen (E603) des decodierten Signals in wenigstens zwei Untersignale gemäß einem vorgegebenen Zerlegungskriterium;
- Berechnen (E604) von Dämpfungsfaktoren pro Untersignal und pro Abtastung einer im Voraus bestimmten Vorechozone;
- Dämpfen (E605) des Vorechos in der Vorechozone jedes der Untersignale durch Anwenden von Dämpfungsfaktoren auf die Untersignale; und
- Erhalten (E606) des gedämpften Signals durch Kombinieren der gedämpften Untersignale.

**2.** Verfahren nach Anspruch 1, **dadurch gekennzeichnet, dass** das vorgegebene Zerlegungskriterium ein frequentielles Kriterium ist.

3. Verfahren nach Anspruch 2, **dadurch gekennzeichnet, dass** die Zerlegung des decodierten Signals durch eine erste Tiefpass- oder Hochpassfilterung erfolgt, um ein erstes Untersignal zu erhalten.

4. Verfahren nach Anspruch 3, **dadurch gekennzeichnet, dass** die Zerlegung des Signals außerdem durch eine zweite Hochpass- oder Tiefpassfilterung, die zu der ersten Filterung komplementär ist, erfolgt, um ein zweites Untersignal zu erhalten.

5. Verfahren nach Anspruch 3, **dadurch gekennzeichnet, dass** ein zweites Untersignal durch Subtrahieren des ersten Untersignals von dem decodierten Signal erhalten wird.

6. Verfahren nach Anspruch 1, **dadurch gekennzeichnet, dass** die Zerlegung des decodierten Signals durch QMF- und PQMF-Filterung erfolgt, um Untersignale in Unterbändern zu erhalten.

7. Verfahren nach Anspruch 1, **dadurch gekennzeichnet, dass** das vorgegebene Zerlegungskriterium ein Kriterium der Periodizität des Signals ist.

8. Verfahren nach Anspruch 1, **dadurch gekennzeichnet, dass** die Vorechozone gemäß den folgenden Schritte bestimmt wird:

    - Detektieren einer Angriffsposition in dem decodierten Signal vor dem Zerlegungsschritt;
    - Bestimmen einer Vorechozone, die der detektierten Angriffsposition vorhergeht, in dem decodierten Signal vor dem Zerlegungsschritt oder in den Untersignalen nach dem Zerlegungsschritt.

9. Verfahren nach Anspruch 1, **dadurch gekennzeichnet, dass** die Vorechozone gemäß den folgenden Schritten bestimmt wird:

    - Detektieren einer Angriffsposition in jedem der Untersignale, die nach dem Zerlegungsschritt erhalten werden;
    - Bestimmen einer Vorechozone, die der detektierten Angriffsposition vorhergeht, in jedem der Untersignale.

10. Verfahren nach Anspruch 8, **dadurch gekennzeichnet, dass** für wenigstens ein Untersignal das Berechnen des Dämpfungsfaktors unter Verwendung wenigstens eines Parameters des Schrittes des Detektierens einer Angriffsposition in dem decodierten Signal erfolgt.

11. Verfahren nach Anspruch 1, **dadurch gekennzeichnet, dass** ein Schritt des Glättens des Dämpfungsfaktors für wenigstens ein Untersignal angewendet wird.

12. Verfahren nach Anspruch 1, **dadurch gekennzeichnet, dass** der Dämpfungsfaktor für eine vorgegebene Anzahl von Abtastungen, die dem Beginn des Angriffs vorhergehen, auf 1 gezwungen wird.

13. Vorrichtung für die Verarbeitung der Dämpfung eines Vorechos in einem digitalen Audiosignal, das anhand eines Decodierers durch Transformierte decodiert wird, **dadurch gekennzeichnet, dass** sie Folgendes umfasst:

    - ein Modul (603) zum Zerlegen des decodierten Signals in wenigstens zwei Untersignale gemäß einem vorgegebenen Zerlegungskriterium;
    - ein Modul (604) zum Berechnen von Dämpfungsfaktoren pro Untersignal und pro Abtastung einer im Voraus bestimmten Vorechozone;
    - ein Modul (605) zum Dämpfen des Vorechos in der Vorechozone jedes der Untersignale durch Anwenden der Dämpfungsfaktoren auf die Untersignale;
    - ein Modul (606) zum Erhalten eines gedämpften Signals durch Addieren der gedämpften Untersignale.

14. Decodierer für ein digitales Audiosignal, der eine Vorrichtung nach Anspruch 11 enthält.

15. Datenverarbeitungsprogramm, das Codebefehle für die Ausführung der Schritte des Verfahrens nach einem der Schritte 1 bis 10 umfasst, wenn diese Befehle durch einen Prozessor ausgeführt werden.

**Claims**

1. Method for processing attenuation of pre-echo in a digital audio signal decoded according to a transform decoding, **characterized in that** it comprises the following steps:

   - decomposition (E603) of the decoded signal into at least two sub-signals according to a predetermined decomposition criterion;
   - computation (E604) of attenuation factors per sub-signal and per sample of a previously determined pre-echo zone;
   - attenuation (E605) of pre-echo in the pre-echo zone of each of the sub-signals by application of the attenuation factors to the sub-signals; and
   - obtaining (E606) of the attenuated signal by combination of the attenuated sub-signals.

2. Method according to Claim 1, **characterized in that** the predetermined decomposition criterion is a frequency criterion.

3. Method according to Claim 2, **characterized in that** the decomposition of the decoded signal is performed by a first low-pass or high-pass filtering to obtain a first sub-signal.

4. Method according to Claim 3, **characterized in that** the decomposition of the signal is performed further by a second high-pass or low-pass filtering, complementing the first filtering, to obtain a second sub-signal.

5. Method according to Claim 3, **characterized in that** a second sub-signal is obtained by subtraction of the first sub-signal from the decoded signal.

6. Method according to Claim 1, **characterized in that** the decomposition of the decoded signal is performed by QMF and PQMF filtering to obtain sub-signals in subbands.

7. Method according to Claim 1, **characterized in that** the predetermined decomposition criterion is a criterion of periodicity of the signal.

8. Method according to Claim 1, **characterized in that** the pre-echo zone is determined according to the following steps:

   - detection of an onset position in the decoded signal, before the decomposition step;
   - determination of a pre-echo zone preceding the onset position detected in the decoded signal before the decomposition step or in the sub-signals after the decomposition step.

9. Method according to Claim 1, **characterized in that** the pre-echo zone is determined according to the following steps:

   - detection of an onset position in each of the sub-signals obtained after the decomposition step;
   - determination of a pre-echo zone preceding the onset position detected in each of the sub-signals.

10. Method according to Claim 8, **characterized in that**, for at least one sub-signal, the computation of the attenuation factor is performed by using at least one parameter from the step of detection of an onset position in the decoded signal.

11. Method according to Claim 1, **characterized in that** a step of smoothing of the attenuation factor is applied for at least one sub-signal.

12. Method according to Claim 1, **characterized in that** the attenuation factor is forced to 1 for a predetermined number of samples preceding the start of the onset.

13. Device for processing attenuation of pre-echo in a digital audio signal decoded from a transform decoder, **characterized in that** it comprises:

   - a module (603) for decomposing the decoded signal into at least two sub-signals according to a predetermined decomposition criterion;
   - a module (604) for computing attenuation factors per sub-signal and per sample of a previously determined pre-echo zone;
- a module (605) for attenuating pre-echo in the pre-echo zone of each of the sub-signals by application of the attenuation factors to the sub-signals;
- a module (606) for obtaining the attenuated signal by addition of the attenuated sub-signals.

14. Decoder of a digital audio signal comprising a device according to Claim 11.

15. Computer program comprising code instructions for implementing the steps of the method according to one of Claims 1 to 10, when these instructions are executed by a processor.

FIG.1

FIG.2

**FIG.3**

FIG.4

FIG.5b

FIG.5a

**FIG.6**

EP 2 936 488 B1

EP 2 936 488 B1

**FIG.7a**

FIG.7b

EP 2 936 488 B1

Ana.

Synth.

M

FIG.8

EP 2 936 488 B1

FIG.9

FIG.10

**FIG.11**

EP 2 936 488 B1

**FIG.12a**

**FIG.12b**

**FIG.12c**

EP 2 936 488 B1

FIG.13

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 0856248
- FR 2897733

- FR 2888704

**Littérature non-brevet citée dans la description**

- **Y. MAHIEUX ; J. P. PETIT.** High Quality Audio Transform Coding at 64 kbits. *IEEE Trans. on Communications,* Novembre 1994, vol. 42 (11
- **B. KÖVESI ; S. RAGOT ; M. GARTNER ; H. TADDEI.** Pre-echo réduction in the ITU-T G.729.1 embedded coder. *EUSIPCO, Lausanne, Suisse,* Août 2008

- G.729 based Embedded Variable bit-rate coder: An 8-32 kbit/s scalable wideband coder bitstream interoperable with G.729. *ITU-T Recommendation G.729.1,* Mai 2006